# EUROPÄISCHE PATENTSCHRIFT

(11) **EP 0 505 928 B1**
(45) Veröffentlichungstag und Bekanntmachung des Hinweises auf die Patenterteilung: **12.06.2002**
(21) Anmeldenummer: 92104811.2
(22) Anmeldetag: 19.03.1992
(51) Int. Cl.: H01L 21/268, H01L 21/00

(54) **Verfahren zum Kurzzeittempern einer Halbleiterscheibe durch Bestrahlung**
Process for the rapid thermal annealing of a semiconductor wafer using irradiation
Procédé de traitement thermique rapide d'une plaquette semi-conductrice par irradiation

(30) Priorität: 26.03.1991 DE 4109956
(43) Veröffentlichungstag der Anmeldung: 30.09.1992
(73) Patentinhaber: Infineon Technologies AG, 81669 München (DE)
(72) Erfinder: Kakoschke, Ronald, Dr. rer. nat., W-8000 München 71 (DE)
(74) Vertreter: Kindermann, Peter, Dipl.-Ing.

(56) Entgegenhaltungen:
- EP-A- 0 345 443
- PATENT ABSTRACTS OF JAPAN vol. 13, no. 181 (E-750) (3529) 27. April 1989 & JP-A-01 007 519 (OKI ELECTRIC IND CO LTD)
- PATENT ABSTRACTS OF JAPAN vol. 13, no. 78 (E-718) 22. Februar 1989 & JP-A-63 260 018 (HITACHI LTD)

## Beschreibung

Die Erfindung betrifft eine Vorrichtung zum Kurzzeittempern einer Halbleiterscheibe durch elektromagnetische Bestrahlung gemäß Oberbegriff des Patentanspruchs 1. Die Vorrichtung enthält eine Bestrahlungsanordnung zur Erwärmung der Halbleiterscheibe, die aus mehreren Lichtquellen besteht, durch deren Licht die Halbleiterscheibe mindestens einseitig bestrahlt wird.

Eine derartige Vorrichtung ist beispielsweise aus der EP 0 345 443 A2, insbesondere Figur 6, bekannt. Andere Tempervorrichtungen sind aus der Zusammenfassung der japanischen Patentanmeldung JP1007519 und aus der Zusammenfassung der japanischen Patentanmeldung JP 63260018 bekannt.

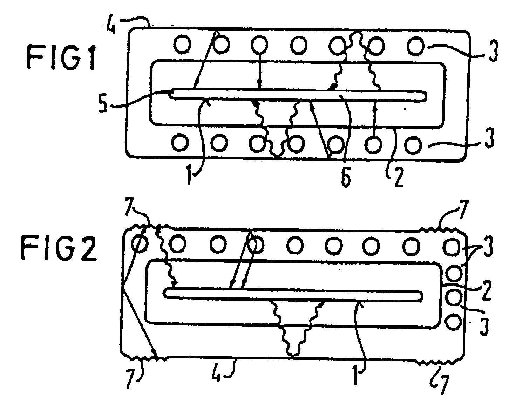

Bei der Herstellung elektronischer Bauelemente auf Halbleiterscheiben auf Silizium- oder Galliumarsenidbasis gewinnen Kurzzeittemperverfahren (englisch: Rapid Thermal Processing = RTP oder Rapid Thermal Anealing = RTA) immer mehr an Bedeutung. Deren Hauptvorteile, eine verringerte Temperaturbelastung und ein rationeller Fertigungsprozeß, werden unter anderem bei der Herstellung dünner Dielektrika, bei Silizierreaktionen und beim Verfließen von Schichten, z.B. aus Borphosphorsilikatglas, ausgenutzt. Dabei werden die Halbleiterscheiben einzeln in eine Prozeßkammer gefahren und dann unter definierter Atmosphäre durch Bestrahlung mit einer intensiven Lichtquelle sehr schnell und möglichst homogen aufgeheizt. Ein typischer Temperatur-Zeit-Zyklus ist z. B. eine Aufheizrate von 300°C/sec auf 1100°C, eine anschließende Temperzeit von 5 sec bei 1100°C und eine Abkühlrate von 100°C/Sec. Eine wichtige Voraussetzung zur Erzielung hoher Ausbeuten bei Kurzzeittemperprozessen ist eine ausreichend homogene Temperaturverteilung über der Halbleiterscheibe. Diese Anforderung stellt jedoch vor allem bei großen Halbleiterscheibendurchmessern ein noch nicht befriedigend gelöstes Problem dar, das im folgenden anhand von FIG 1 erläutert wird.

In FIG 1 ist ein weitverbreiteter RTP-Anlagentyp schematisch und im Schnitt dargestellt. Die aufzuheizende Halbleiterscheibe 1 befindet sich üblicherweise in einer Quarzkammer 2. Die Lichtquelle besteht aus zwei Reihen von Quarz-Halogen-Lampen (Lampenbänke 3). Der Reflektor in Form einer quaderförmigen Reflektionskammer 4, der die Lampen und die Halbleiterscheibe 1 umschließt, sorgt einerseits dafür, daß möglichst geringe Verluste des Lampenlichts auftreten, andererseits auch dafür, daß die Verluste durch die Wärmeabstrahlung von der heißen Halbleiterscheibe 1 gering gehalten werden. Bei vielen RTP-Systemen ist es nur dann möglich, hohe Temperaturen (> 1100°C) und ein schnelles Hochheizen zu erzielen, wenn die von den Lampenbänken abgedeckte Fläche größer als die Waferfläche ist und die Verluste minimal gehalten werden.

In FIG 1 ist das von den Lampen abgestrahlte und möglicherweise ein- oder mehrfach an den Wänden der Reflektionskammer 4 reflektierte Licht durch durchgezogene Pfeile, die Wärmeabstrahlung hingegen durch gewellte Pfeile angedeutet. Aus der obengenannten europäischen Patentanmeldung ist bekannt, daß sich aufgrund der zusätzlichen Fläche am Halbleiterscheibenrand 5 die Wärmeabstrahlung dort erhöht, was zu einer gegenüber der Halbleiterscheibenmitte 6 verringerten Temperatur führt. Eine homogene Intensitätsverteilung des Lichts hat - zusammen mit der inhomogenen Intensitätsverteilung der Wärmeabstrahlung - deshalb eine insgesamt inhomogene Temperaturverteilung über der Halbleiterscheibe 1 zur Folge. Eine bekannte Möglichkeit dies zu korrigieren, besteht darin, den Halbleiterscheibenrand 5 mit - im Vergleich zur Halbleiterscheibenmitte 6 - erhöhter Intensität zu bestrahlen, wobei das Verhältnis der Intensitäten während des gesamten Temperprozesses konstant ist. Im Ergebnis stellt sich bei diesem Verfahren zwar eine homogene Temperaturverteilung ein, jedoch wird die Solltemperatur erst nach einer gewissen Zeit erreicht, die von der thermischen Masse der Halbleiterscheibe 1 und dem Betrag der Solltemperatur abhängt und für 6-Zoll-Scheiben etwa 5 bis 10 sec beträgt. Gebiete am Halbleiterscheibenrand 5 können deshalb bei kurzen Temperzeiten (5 sec) im Mittel eine um bis zu 50°C höhere Temperaturbelastung als Gebiete in der Halbleiterscheibenmitte 6 erfahren.

Der unterschiedliche Temperatur-Zeit-Verlauf am Rand und in der Mitte der Halbleiterscheibe wirkt sich letztlich negativ auf die Ausbeute, insbesondere bei großen Scheiben, in der Produktion von elektronischen Bauelementen auf Siliziumbasis aus. Im genannten Stand der Technik wird deshalb vorgeschlagen, die zusätzliche Wärmeabstrahlung im Randbereich der Halbleiterscheibe durch eine zusätzliche, auf den Randbereich gerichtete Bestrahlung auszugleichen, deren Intensität jedoch zeitlich veränderbar ist und mittels Temperaturmessung oder anhand vorherberechneter Kurvenwerte so gesteuert wird, daß sich insgesamt eine homogene Temperaturverteilung während des gesamten Temperprozesses einstellt. Konkret wird als Mittel zur zusätzlichen Bestrahlung beispielsweise ein zusätzlicher Reflektionsschirm mit halbkreisförmig gewölbtem Querschnitt vorgeschlagen, der so um den Halbleiterscheibenrand angeordnet wird, daß die von dort ausgehende Wärmeabstrahlung selbstregelnd wieder auf den Halbleiterscheibenrand zurückreflektiert wird. Bei einem weiteren Ausführungsbeispiel mit quaderförmiger, die Lampen ganz umschließender Reflektionskammer wird vorgeschlagen, zum Ausgleich der Temperaturunterschiede über der Halbleiterscheibe den Abstand Reflektor-Halbleiterscheibe zu variieren. Dieses bekannte Verfahren ist jedoch aufgrund der komplexen Regelung und/oder zusätzlicher Lichtquellen relativ aufwendig und außerdem kompliziert zu handhaben.

Grundsätzlich ist die Temperaturverteilung über die Halbleiterscheibe durch die Verteilung der folgenden zwei Strahlungsbeiträge bestimmt:
1. Intensitätsverteilung des Lampenlichts einschließlich Mehrfachreflexionen an der Scheibe und am Reflektor
2. Intensitätsverteilung der Wärmeabstrahlung der Scheibe, die gegebenenfalls auf diese zurückreflektiert wird (gleichbedeutend mit einer Verminderung der Verluste relativ zu dem Fall ohne Rückreflexion).

Weiter oben wurde bereits die Möglichkeit angedeutet, inhomogene Verluste, die im allgemeinen am Scheibenrand größer sind als in der Mitte, durch Erhöhung der Intensität des Lampenlichts am Rand der Scheibe relativ zur Scheibenmitte zu kompensieren. Die Lampenintensität kann aber nur so eingestellt werden, daß eine Kompensation nur für einen bestimmten Temperatur-Zeit-Zyklus erfolgt. Sie muß daher spezifisch für jeden Zyklus neu angepaßt werden, da sonst bei kürzeren Zeiten oder schnellerem Hochheizen die transiente Temperaturverteilung, oder umgekehrt bei längeren Zeiten oder langsamerem Hochheizen die stationäre Temperaturverteilung an Gewicht gewinnt. Die Problematik besteht unter anderem darin, daß zwar Maßnahmen bekannt sind, die z. B. die gleichmäßige Verteilung der Verluste verbessern, diese Maßnahmen andererseits jedoch gleichzeitig die Verteilung des Lampenlichts verschlechtern. Auch ein Verzicht auf die Reflektion der Wärmeabstrahlung der Scheibe durch Verwendung einer sogenannten schwarzen Kammer führt nicht zum Ziel. Zum einen werden die Verluste so groß, daß sehr leistungsstarke Lampen mit erhöhtem Platzbedarf - nicht zuletzt auch für die Stromversorgung - eingesetzt werden müssen. Da außerdem eine beidseitige Bestrahlung nötig ist, um durch Strukturen verursachte Temperaturgradienten im Wafermaterial zu vermeiden, würden derartige Apparaturen sehr groß. Auch alle anderen bisher vorgeschlagenen Lösungen sind nicht ohne nachteilige Aspekte.

Aufgabe der Erfindung ist es, eine Vorrichtung der eingangs genannten Art anzugeben, die Aufgrund ihres Aufbaus eine hohe Homogenittät der Temperaturverteilung zwischen Zentrum und Peripherie der Halbleiterscheibe während des gesamten Temperprozesses gewährleistet.

Diese Aufgabe wird durch eine Vorrichtung der eingangs genannten Art gelöst, die eine als Reflektor verwendete Reflexionskammer mit Reflektorwänden enthält. In den Randbereichen in der oberen und unteren Reflektorwand sind Tripelspiegel oder Spiegellinsen angeordnet.

Weiterbildungen der Erfindung sind Gegenstand von Unteransprüchen.

Der Erläuterung von Ausführungsbeispielen der Erfindung werden folgende für das Verständnis der Wirkungsweise der Erfindung wesentliche Überlegungen vorangestellt.

Die detaillierte Untersuchung der Ursachen für inhomogene Intensitätsverteilungen der obengenannten beiden Strahlungsbeiträge ergab, daß Wärmestrahlung, welche weit genug entfernt vom Scheibenrand und unter einem kleinen Winkel zur Scheibennormalen emittiert wird, bereits nach einer Reflexion auf die Scheibe zurückgelangt, während nahe dem Scheibenrand unter kleinem Winkel emittierte Wärmestrahlung erst nach mehreren Reflexionen, bei denen bevorzugt wieder der Scheibenrand getroffen wird, auf die Scheibe zurückgelangt. Ähnlich gelangt Licht, welches weit genug von der Projektion des Scheibenrands (aber innerhalb der Projektion) auf die Ebene der Lampenbank und unter einem kleinen Winkel zur Scheibennormalen emittiert wird, direkt oder spätestens nach einer Reflexion auf die Scheibe, während Licht, das unter kleinem Winkel innerhalb der Projektion in der Nähe des Scheibenrandes emittiert wird, erst nach mehreren Reflexionen auf die Scheibe zurückgelangt. Dabei wird wiederum bevorzugt der Scheibenrand getroffen. Innerhalb der Projektion gilt hinsichtlich Wärmestrahlung und Bestrahlung mit Licht gleichermaßen, daß ihre Intensitätsverteilung homogen wäre, wenn das Reflexionsvermögen des Reflektormaterials ideal wäre. In der Praxis ist der Wert der Reflektivität jedoch nicht 1, sondern seine typischen Warte sind 0,9 bis 0,95. Aus diesem Grund ist am Scheibenrand die Intensität der zurückreflektierten Wärmeabstrahlung und die Intensität des Lampenlichts wegen der Mehrfachreflexionen geringer.

Wird andererseits Licht außerhalb der Scheibenprojektion unter kleinen Winkeln zur Scheibennormalen emittiert, so führt dies zu einer zusätzlichen Bestrahlung des Scheibenrandes, d. h. zu einer Intensitätserhöhung. Entsteht mehr Licht außerhalb der Scheibenprojektion als zur Kompensation der Verluste durch Mehrfachzeflexionen notwendig ist, so hat dies zur Folge, daß die Intensität des Lampenlichts am Waferrand höher als in der Scheibenmitte ist. Die zurückreflektierte Wärmeabstrahlung dagegen ist in jedem Fall am Scheibenrand niedriger.

Da sich ferner herausstellte, daß Licht, welches unter einem großen Winkel zur Scheibennormalen abgestrahlt wird, sich in allen Fällen gleichmäßig über der Halbleiterscheibe verteilt, wird angestrebt, einen Reflektor zu entwerfen, bei dem sowohl die Intensitätsverteilung des Lampenlichts als auch die Verluste durch Wärmeabstrahlung homogen sind.

Im folgenden wird die Erfindung anhand mehrerer Ausführungsbeispiele und der Zeichnung näher erläutert. Es zeigen
- FIG 2: schematisch und im Schnitt als erstes Ausführungsbeispiel eine Anordnung, und
- FIC 3: die Verteilung der Temperatur über der Halbleiterscheibe beim Stand der Technik und bei der Erfindung, jeweils in Abhängigkeit vom Abstand zur Scheibenmitte.

In FIG 2 ist im Gegensatz zu FIG 1 eine primär einseitige Bestrahlung der Oberseite der Halbleiterscheibe 1 durch eine parallel zur Stirnfläche der Halbleiterscheibe 1 angeordnete Lampenbank 3 dargestellt. Sofern die Platzerfordernisse es erlauben, ist es jedoch hier und in den folgenden Ausführungsbeispielen vorteilhaft, auch anders angeordnete Lichtquellen zu verwenden.

FIG 2 zeigt eine quaderförmige Reflektionskammer 4, in deren Reflektorwänden Rückstrahler 7, vorzugsweise Tripelspiegel oder Spiegellinsen, angeordnet sind. Die Rückstrahler 7 können, wie dargestellt, in den Randbereichen der oberen und unteren Reflektorwand eingebaut werden, sie können jedoch auch die gesamte Fläche der Reflektorwände bedecken. Durch die Rückstrahler werden Mehrfachreflexionen von Licht und Wärmeabstrahlung mit kleinem Winkel zur Scheibennormalen am Scheibenrand verhindert, wobei jedoch die hohe Reflektivität des Reflektors, die ansonsten durch Wahl von Gold oder Aluminium als Material für die Reflektorwände sichergestellt wird, weitestgehend beibehalten wird. Wärmeabstrahlung und Licht innerhalb der Scheibenprojektion (mit kleinem Winkel und nahe dem Scheibenrand) werden durch die Rückstrahler 7 in sich zurückreflektiert und gelangen bereits nach einer Reflexion wieder auf die Halbleiterscheibe 1. Andererseits wird Lampenlicht, welches außerhalb der Scheibenprojektion unter kleinem Winkel emittiert wird und, wie weiter oben beschrieben, zu einer Intensitätserhöhung am Scheibenrand führen würde, zwischen den Rückstrahlern 7 der oberen und unteren Reflektorwand hin- und herreflektiert und gelangt nicht auf die Halbleiterscheibe 1.

Bei einer der häufig benutzten quaderförmigen Reflektionskammern 4 wirken die Ecken teilweise als Rückstrahler 7 (Tripelspiegel). Die Höhe derartiger Reflektionskammern ist üblicherweise kleiner als deren Breite bzw. als deren Tiefe. Die reflektierten Strahlen laufen aufgrund der Quaderform jedoch nicht in sich zurück, sondern sind parallel versetzt. Verwendet man eine würfelförmige Reflektionskammer, deren Kantenlänge etwa 1,3 mal größer als der Scheibendurchmesser ist, so wird durch diese Anpassung der Kantenlänge an den Scheibendurchmesser die Rückstrahlerwirkung optimal ausgenutzt und die Intensitätsverteilung der zurückreflektierten Wärmeabstrahlung ist sehr homogen. Um auch die Intensitätsverteilung des Lampenlichts homogen werden zu lassen, werden die Lampen so angeordnet, daß nur soviel Licht außerhalb der Scheibenprojektion entsteht, als zur Kompensation der Verluste durch mehrfache Reflexionen notwendig ist.

Bei allen Ausführungsbeispielen wirkt es sich günstig aus, wenn die Fläche in der Scheibenebene zwischen Scheibenrand und den Reflektorwänden sehr klein ist, so daß kaum mehrfache Reflexionen stattfinden können. Eine zylindrische Reflektionskammer, deren Zylinderradius dem Scheibenradius angepaßt ist (z. B. Zylinderradius ≤ Scheibenradius + 0,5 cm), erfüllt diese Forderung am besten.

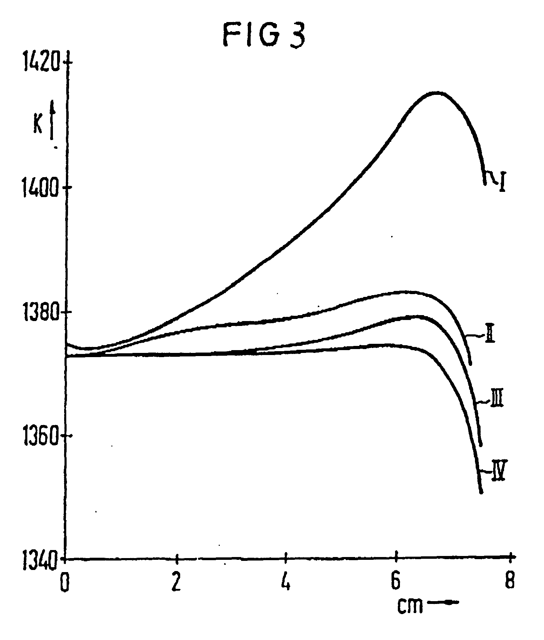

Als typische Temperzyklen für die gegebenen Ausführungsbeispiele werden folgende Werte vorgeschlagen:
Zyklus 1 (vergleiche Kurve I und III in FIG 3):
   Hochheizen mit 200°C/sec auf 1100°C
   Verbleiben auf 1100°C für 5 sec
   Abkühken durch die natürliche Wärmeabstrahlung
Zyklus 2 (vergleiche Kurve II und IV in FIG 3):
   Hochheizen mit 20°C/sec auf 1100°C
   Verbleiben auf 1100°C für 30 sec
   Abkühlen durch die natürliche Wärmeabstrahlung

FIG 3. zeigt ein Diagramm in dem die zu erwartenden, theoretisch errechneten, gemittelten Temperaturverteilungen dargestellt sind. Bei einem den herkömmlichen Verfahren entsprechenden Reaktor (z. B. Höhe = 10 cm, Breite = 20 cm, Tiefe = 20 cm) tritt nicht nur die bekannte unerwünschte Temperaturerhöhung. am Randbereich der Halbleiterscheibe auf (vergleiche Kurve I und II), sondern es zeigt sich auch ein großer Unterschied der Temperaturverteilungen nach Zyklus 1 (Kurve I) und Zyklus 2 (Kurve II), was bei der Erfindung (Kurve III und IV) nicht der Fall ist. Insgesamt belegen diese Kurven die deutliche Verbesserung, die durch die in den Ausführungsbeispielen beschriebenen Maßnahmen eintritt.

## Patentansprüche

1. Vorrichtung zum Kurzzeittempern einer Halbleiterscheibe (1) durch elektromagnetische Bestrahlung,
mit einer zur Erwärmung der Halbleiterscheibe (1) dienenden Bestrahlungsanordnung, die aus mehreren Lichtquellen besteht, durch deren Licht die Halbleiterscheibe (1) mindestens einseitig bestrahlt wird,
wobei die Bestrahlungsanordnung, insbesondere ein Reflektordesign, so beschaffen ist, daß bei Ausführung des Verfahrens zum Kurzzeittempern die Halbleiterscheibe (1) so bestrahlt wird, dass eine gleiche Temperatur im mittleren und im Randbereich der Halbleiterscheibe mittels einer je für sich über der Halbleiterscheibe (1) homogenen Intensitätsverteilung des Lichts und der Wärmestrahlung der Halbleiterscheibe (1) erzielt wird,
**gekennzeichnet durch** eine als Reflektor verwendete Reflexionskammer (4), die die Halbleiterscheibe (1) und die Lichtquellen ganz einschließt, die eine zur Halbleiterscheibe (1) parallele obere Reflektorwand und die eine zur Halbleiterscheibe (1) parallele untere Reflektorwand enthält,
und **durch** in den Randbereichen in der oberen und unteren Reflektorwand angeordnete Tripelspiegel oder Spiegellinsen.

2. Vorrichtung nach Anspruch 1, **gekennzeichnet durch** eine Quarzkammer (2) zum Umgeben der Halbleiterscheibe (1).

3. Vorrichtung nach Anspruch 1 oder 2, **dadurch gekennzeichnet, daß** die Reflexionskammer quaderförmig ist.

4. Vorrichtung nach Anspruch 3, **dadurch gekennzeichnet, daß** eine quaderförmige Reflexionskammer (4) verwendet wird, deren Höhe etwa gleich oder größer als ihre Breite ist.

5. Vorrichtung nach Anspruch 4, **dadurch gekennzeichnet, daß** eine würfelförmige Reflexionskammer (4) verwendet wird, deren Kantenlänge etwa 1,3 mal größer als der Durchmesser der Halbleiterscheibe (1) ist,
wobei die Lichtquellen vorzugsweise so angeordnet werden, daß außerhalb der Scheibenprojektion nur ein geringer Beitrag zur Intensitätsverteilung des Lichtes entsteht.

6. Vorrichtung nach Anspruch 4, **dadurch gekennzeichnet, daß** eine quaderförmige Reflexionskammer (4) verwendet wird, deren Höhe mehr als 2 mal größer als der Durchmesser der Halbleiterscheibe (1) ist.

7. Vorrichtung nach Anspruch 1 oder 2, **dadurch gekennzeichnet, daß** eine zylindrische Reflexionskammer verwendet wird, deren Zylinderradius nur wenig, insbesondere etwa 0,5 cm, größer als der Radius der Halbleiterscheibe (1) ist.

8. Vorrichtung nach einem der vorhergehenden Ansprüche, **dadurch gekennzeichnet, daß** für den Reflektor Materialien hoher Reflektivität verwendet werden, insbesondere Gold oder Aluminium.

9. Vorrichtung nach einem der vorherigen Ansprüche, **dadurch gekennzeichnet, daß** die Lichtquellen als Lampenbank (3) angeordnet sind.

## Claims

1. Apparatus for the rapid thermal processing of a semiconductor wafer (1) by electromagnetic radiation,
having a radiation arrangement which is used to heat the semiconductor wafer (1) and comprises a plurality of light sources, the light from which is used to irradiate the semiconductor wafer (1) on at least one side,
the radiation arrangement, in particular a reflector design, being created in such a way that, when the method for rapid thermal processing is being carried out, the semiconductor wafer (1) is irradiated in such a way that a uniform temperature is achieved in the central and edge regions of the semiconductor wafer by means of an intensity distribution of the light and of the thermal radiation applied to the semiconductor wafer (1) which is in each case homogenous over the semiconductor wafer (1),
**characterized by** a reflection chamber (4) which is used as the reflector, completely encloses the semiconductor wafer (1) and the light sources and includes an upper reflector wall, which is parallel to the semiconductor wafer (1), and a lower reflector wall, which is parallel to the semiconductor wafer (1),
and by tube corner reflectors or mirror lenses arranged in the edge regions in the upper and lower reflector walls.

2. Apparatus according to Claim 1, **characterized by** a quartz chamber (2) for surrounding the semiconductor wafer (1).

3. Apparatus according to Claim 1 or 2, **characterized in that** the reflection chamber is of cuboidal design.

4. Apparatus according to Claim 3, **characterized in that** a cuboidal reflection chamber (4), the height of which is approximately equal to or greater than its width, is used.

5. Apparatus according to Claim 4, **characterized in that** a cube-shaped reflection chamber (4), the edge length of which is approximately 1.3 times greater than the diameter of the semiconductor wafer (1), is used,
the light sources preferably being arranged in such a way that outside the wafer projection only a small contribution is made to the intensity distribution of the light.

6. Apparatus according to Claim 4, **characterized in that** a cuboidal reflection chamber (4), the height of which is more than twice as great as the diameter of the semiconductor wafer (1), is used.

7. Apparatus according to Claim 1 or 2, **characterized in that** a cylindrical reflection chamber, the cylinder radius of which is only slightly greater, in particular approximately 0.5 cm greater, than the radius of the semiconductor wafer (1), is used.

8. Apparatus according to one of the preceding claims, **characterized in that** materials with a high reflectivity, in particular gold or aluminium, are used for the reflector.

9. Apparatus according to one of the preceding claims, **characterized in that** the light sources are arranged as an array of lamps (3).

## Revendications

1. Installation de traitement thermique rapide d'une plaquette (1) semi-conductrice en l'exposant à un rayonnement électromagnétique,
comprenant un dispositif d'exposition à un rayonnement servant à réchauffer la plaquette (1) semi-conductrice et constitué de plusieurs sources de lumière, à la lumière desquelles la plaquette (1) semi-conductrice est exposée au moins d'un côté,
le dispositif d'exposition à un rayonnement, notamment ayant un agencement à réflecteur, étant tel que lorsque l'on effectue le procédé de traitement thermique rapide, la plaquette (1) semi-conductrice est exposée à un rayonnement de sore que l'on obtient une même température au milieu et dans la zone du bord de la plaquette semi-conductrice au moyen d'une répartition respective homogène sur la plaquette (1) semi-conductrice des intensités de la lumière et de l'émission de chaleur de la plaquette (1) semi-conductrice,
**caractérisée par** une chambre (4) de réflexion qui est utilisée comme réflecteur, qui enferme entièrement la plaquette (1) semi-conductrice et les sources de lumière, qui a une paroi supérieure formant réflecteur parallèle à la plaquette (1) semi-conductrice et qui a une paroi inférieure formant réflecteur parallèle à la plaquette (1) semi-conductrice et par des miroirs triples ou des dispositifs catadioptriques montés dans les zones de bord dans la paroi supérieure et inférieure formant réflecteur.

2. Installation suivant la revendication 1, **caractérisé par** une chambre (2) de quartz pour entourer la plaquette (1) semi-conductrice.

3. Installation suivant la revendication 1 ou 2, **caractérisée en ce que** la chambre de réflexion est parallélépipédique.

4. Installation suivant la revendication 3, **caractérisée en ce qu'**il est utilisé une chambre (4) de réflexion parallélépipédique dont la hauteur est à peu près égale ou supérieure à sa largeur.

5. Installation suivant la revendication 3, **caractérisée en ce qu'**il est utilisé une chambre (4) de réflexion cubique dont la longueur de l'arête est environ 1,3 fois plus grande que le diamètre de la plaquette (1) semi-conductrice, les sources de lumière étant disposées de préférence de façon à ne donner à l'extérieur de la projection de la plaquette qu'une petite contribution à la répartition des intensités de la lumière.

6. Installation suivant la revendication 4, **caractérisée en ce qu'**il est utilisé une chambre (4) de réflexion parallélépipédique dont la hauteur est plus de deux fois plus grande que le diamètre de la plaquette (1) semi-conductrice.

7. Installation suivant la revendication 1 ou 2, **caractérisée en ce qu'**il est utilisé une chambre de réflexion cylindrique dont le rayon du cylindre n'est plus grand que de peu, notamment que d'environ 0,5 cm que le rayon de la plaquette (1) semi-conductrice.

8. Installation suivant l'une des revendications précédentes, **caractérisée en ce qu'**il est utilisé pour le réflecteur des matériaux ayant un grand facteur de réflexion, notamment de l'or ou de l'aluminium.

9. Installation suivant l'une des revendications précédentes, **caractérisée en ce que** les sources de lumière sont disposées sous la forme d'un banc (3) de lampe.
